# EUROPÄISCHE PATENTANMELDUNG

(11) **EP 4 375 893 A1**
(43) Veröffentlichungstag der Anmeldung: **29.05.2024**
(21) Anmeldenummer: 23206836.1
(22) Anmeldetag: 30.10.2023
(51) Int. Cl.: G06N 20/00, G06N 5/00, G06F 30/00, G05B 19/00, C21D 9/46, G05B 17/00, C21D 7/13, C21D 8/02, B21B 45/00, B21B 37/00, B21B 1/00, G05B 13/00

(54) **VERFAHREN ZUM HERSTELLEN EINES STAHLBANDES AUS EINEM VORPRODUKT, BEI DEM DIE SOLLWERTE ÜBER DIE LÄNGE EINES EINZELNEN STAHLBANDES UND / ODER ZEITLICH IN BEZUG AUF EINE EINZELNE PRODUKTIONSANLAGE EINER WALZTRASSE VARIABEL VORGEGEBEN WERDEN**

(30) Priorität: 25.11.2022 DE 102022212627
(71) Anmelder: SMS Group GmbH, 40237 Düsseldorf (DE)
(72) Erfinder: Boushmelev, Alexander, 57271 Hilchenbach (DE); Buschhoff, Guido, 57271 Hilchenbach (DE); Hassel, Christoph, 47249 Duisburg (DE); Sprock, August, 40474 Düsseldorf (DE)
(74) Vertreter: Klüppel, Walter

(57) **Zusammenfassung**

Die Erfindung betrifft ein Verfahren zum Herstellen eines Stahlbandes aus einem Vorprodukt bei dem die Sollwerte über die Länge eines einzelnen Stahlbandes und/oder zeitlich in Bezug auf eine einzelne Produktionsanlage einer Walzstraße variabel vorgegeben werden. Das Stahlband wird in diskrete Abschnitte unterteilt und verschiedene Modelle mit unterschiedlichen Modellansätzen geben für unterschiedliche Bereiche des Stahlbandes abweichende Sollwerte vor und passen diese im Produktionsverlauf an.

## Beschreibung

Verfahren zum Herstellen eines Stahlbandes aus einem Vorprodukt, bei dem die Sollwerte über die Länge eines einzelnen Stahlbandes und / oder zeitlich in Bezug auf eine einzelne Produktionsanlage einer Walzstraße variabel vorgegeben werden.

### Gebiet:

Die Erfindung betrifft ein Verfahren zum Herstellen eines Stahlbandes aus einem Vorprodukt bei dem die Sollwerte über die Länge eines einzelnen Stahlbandes und/oder zeitlich in Bezug auf eine einzelne Produktionsanlage einer Walzstraße variabel vorgegeben werden.

### Stand der Technik:

Stahlbänder werden aus einem Vorprodukt, beispielsweise einer Bramme, in Walzwerken mit mehreren unterschiedlichen Prozessschritten und / oder unterschiedlichen Anlagen hergestellt. Ausgehend von einer Definition von ZielWerten des Stahlbandes, wie beispielsweise einer geometrischen Abmessung, einem Coil-Gewicht oder den Werkstoffeigenschaften des Stahls, werden Soll-Werte für die unterschiedlichen Prozessschritte in den Anlagen des Walzwerkes durch einen Fachmann und/oder eine Prozesssteuerung ermittelt. Diese Soll-Werte werden für die Herstellung des Stahlbandes der Anlagensteuerung vorgegeben. Während der Produktion des einzelnen Stahlbandes oder einer Abfolge von mehreren gleichartigen Stahlbändern überwacht eine Steuerung oder Regelung die Einhaltung dieser vorgegebenen Soll-Werte der bei der Herstellung beteiligten Anlagen des Walzwerkes und greift ggf. korrigierend ein.

Nach dem letzten Verarbeitungsschritt im Walzwerk wird das fertige Stahlband auf das Erreichen der vorgegebenen Ziel-Werte hin überprüft. Sofern die Ziel-Werte eingehalten sind, bleiben die Soll-Werte unverändert. Werden die Ziel-Werte nicht eingehalten, können für eine erneute Produktion geänderte Soll-Werte den Anlagen des Walzwerkes vorgegeben werden.

Aus der Druckschrift EP 3 09 68 96 A1 ist ein Verfahren zur optimierten Herstellung eines Stahlbandes in einem Warmwalz- und Grobblechwalzwerk mittels eines Gefügesimulators, -monitors und/oder -models bekannt. Ausgehend von zu erreichenden mechanischen Ziel-Werte des zu produzierenden Warmbandes und den verfügbaren Aggregaten der Walzstraße werden mittels eines Gefügemodells die resultierenden Gefügebestandteile des Warmbandes auf Basis von Ist-Werten der Produktion bestimmt. Bei Abweichungen des Ist-Gefüges vom Ziel-Gefüge werden die Sollvorgaben für die gefügerelevanten Prozessparameter der Warmwalzstraße angepasst.

In der Druckschrift WO 2004/050923 A1 wird ein Verfahren zur Prozesssteuerung oder Prozessregelung einer Anlage zur Umformung, Kühlung und / oder Wärmebehandlung von Metall, insbesondere von Stahl oder Aluminium, offenbart, wobei die Anlage mit Stellgliedern zur Einstellung bestimmter Betriebsparameter ausgerüstet ist und dem Verfahrensprozess ein Verfahrensmodell zugrunde liegt. Mit dem Verfahren ist es möglich online gewünschte Gefügebesonderheiten und unter Verwendung von Gefüge-Eigenschaftsrelationen gewünschte Werkstoffeigenschaften gezielt einzustellen. Dazu soll online mindestens ein aktueller, für das Metallgefüge aussagekräftiger Wert erfasst und in Abhängigkeit dieses Wertes geeignete Prozesssteuerung- und/oder Prozessregelgrössen zur Einwirkung auf die Stellglieder zur Einstellung gewünschter Gefügeeigenschaften des Metalls ermittelt werden.

Aus der WO 2021/160404 A1 ist ein Verfahren zur Ermittlung einer Zielgröße eines Walzgutes von einer Betriebsgröße einer Warmwalzstaße offenbart. Eine Regeleinrichtung für einen Abschnitt eines Warmwalzwerks werden jeweils Primärdaten für mehrere Walzgüter und jeweilige vorläufige Sollwerte für die Zielgrößen des jeweiligen Walzguts zugeführt. Die jeweiligen Primärdaten beschreiben das jeweilige Walzgut, bevor es dem Abschnitt des Warmwalzwerks zugeführt wird. Die jeweiligen vorläufigen Zielwerte der Zielgrößen beschreiben einen gewünschten Zielzustand des jeweiligen Walzguts nach Durchlaufen des Abschnitts des Warmwalzwerks.

Mindestens eine der Zielgrößen ist eine bestimmte Zielgröße, wobei die Steuereinrichtung einen jeweiligen endgültigen Zielwert derart bestimmt, dass sie den jeweiligen vorläufigen Zielwert um einen jeweiligen Offset verändert. Der jeweilige Offset wird unabhängig von den Primärdaten und den anderen speziellen Zielgrößen und den normalen Zielgrößen für das jeweilige Walzgut ermittelt. Der Offset ist auch unabhängig von den für die Handhabung des jeweiligen Walzguts ermittelten Betriebswerten des Warmwalzwerks.

Die anderen Zielgrößen sind normale Zielgrößen, wobei die Steuereinrichtung den jeweiligen vorläufigen Zielwert unverändert als jeweiligen endgültigen Zielwert übernimmt. Bezogen auf die jeweilige Zielgröße weisen die Offsets bei einer Gesamtbetrachtung aller Walzgüter mehrere unterschiedliche Werte auf. Die Steuereinrichtung ermittelt Betriebswerte für den Abschnitt des Warmwalzwerks derart, dass das jeweilige Walzgut nach Durchlaufen des Abschnitts des Warmwalzwerks die endgültigen Sollwerte der Zielgrößen erreicht soweit möglich, und betreibt den Abschnitt des Warmwalzwerks beim Umgang mit dem jeweiligen Walzgut nach den ermittelten Betriebswerten.

Ein Nachteil an den bekannten Verfahren ist, dass das einzelne Warmband die kleinste betrachtete Produktionseinheit ist und insofern die Zielwerte des Warmbandes über die Länge konstant gehalten werden sollen. Die minimale Haspellänge der Warmbandstraße gibt daher die kleinste produzierbare Menge mit homogen definierten Zielwerten für das Stahlband vor. Teilabschnitte des Stahlbandes mit anderen Zielwerten können nicht produziert werden.

Ein weiterer Nachteil der bekannten Verfahren ist, dass von einem weitestgehend homogenen Eigenschaftsprofil des Vorproduktes ausgegangen wird. Unregelmäßigkeiten in vorhergehenden Produktionsschritten können daher nicht ausgeglichen werden.

Zusätzlich sind Gusserzeugnisse nie chemisch homogene Strukturen, da bei der Erstarrung makroskopische Seigerungen innerhalb der Bramme zu einer ungleichmäßigen Verteilung von chemischen Elementen und damit zu Eigenschaftsabweichungen in Bezug die Geometrie der Bramme führt. Sofern die Bearbeitungsparameter in der Walzstraße konstant gehalten werden ergibt sich daraus zwangläufig ein ungleichmäßiges Eigenschaftsprofil im fertigen Warmband. Überlagert werden kann dies zusätzlich von den so genannten Übergangsbrammen, die bei einem Werkstoffwechsel im Strangguss entstehen.

Dadurch führen beispielsweise Übergangsbrammen aus dem Strangguss in Bezug auf die Länge des Warmbandes zu abweichenden Eigenschaften und diese Warmbänder werden dann verschrottet.

### Aufgabe der Erfindung:

Aufgabe der Erfindung ist es daher ein flexibles Verfahren bereitzustellen, dass es ermöglicht zeitlich und örtlich flexibel Soll-Werte für die Herstellung eines Warmbandes in einer Walzstraße vorzugeben und bei dem zeitlich und örtlich flexibel Soll-Werte angepasst werden können.

### Erfindung:

Die Erfindung wird gelöst mit einem Verfahren mit den Merkmalen gemäß dem Anspruch 1 und einer Walzstraße mit den Merkmalen gemäß dem Anspruch 9.

Bei der Herstellung eines Stahlbandes aus einem Vorprodukt werden die Sollwerte über die Länge eines einzelnen Stahlbandes und / oder zeitlich in Bezug auf eine einzelne Produktionsanlage einer Walzstraße variabel vorgegeben, wobei die Herstellung des Stahlbandes mittels der Walzstraße erfolgt und die Walzstraße zumindest ein Wärmeinrichtung, ein Walzgerüst, eine Haspel, eine übergeordnete Prozesssteuerung die in Verbindung mit den Steuerungen der beteiligten Produktionsanlagen steht und Sensoren zur Dickenmessung, zur Profilmessung und / oder einem Sensor zur Messung der chemischen Zusammensetzung aufweist. Die Herstellung des Stahlbandes erfolgt mit den ablaufenden Arbeitsschritten:
- Einteilen des Stahlbandes in diskrete Abschnitte (A_{x,y,z});
- Zuweisen von Zielwerten des Stahlbandes (Z_{x,y,z}) für jeden diskreten Abschnitt (A_{x,y,z}) des Stahlbandes in Bezug auf den auszuführenden Prozessschritt an einer einzelnen Produktionsanlage;
- Zuweisen von Sollwerten für jede auf einer Produktionsanlage der Walzstraße auszuführenden Prozessschrittes mittels eines Prozessmodells;
- Messen von Istwerten (I_{x,y,z}) für eine Vielzahl der diskreten Abschnitte (A_{x,y,z}) des Stahlbandes während der Herstellung des Stahlbandes ;
- Bei Abweichungen der Istwerte (I_{x,y,z}) von den Sollwerten bestimmen und übergeben von neuen Sollwerten durch das Prozessmodell

Die den Produktionsanlagen der Walzstraße zugewiesenen Sollwerte der Prozessschritte werden mittels des Prozessmodells vor und während der Herstellung eines einzelnen Stahlbandes ermittelt und das Prozessmodell berücksichtigt bei der Bestimmung von neuen Sollwerten während der Herstellung eines einzelnen Stahlbandes Ist-Werte (I_{x,y,z}) des in der Herstellung befindlichen Stahlbandes.

Das Prozessmodell weist ein Gefügemodell zur Ermittlung der Sollwerte auf, wobei das Gefügemodell mindestens einen der beiden folgenden Modellansätze verwendet:
i. einen physikalischen Modellansatz, aufweisend physikalische und / oder empirische Gleichungen zum Berechnen von ablaufenden Prozessen im Stahlband, insbesondere der Rekristallisation, der Ausscheidung oder der Umwandlung im Stahlband, um damit die mechanischen Eigenschaften des Stahlbandes zu unterschiedlichen Zeitpunkten während der Herstellung und / oder in unterschiedlichen diskreten Abschnitten (A_{x,y,z}) zu berechnen,
ii. einen physikalischen Modellansatz in Verbindung mit einem datengetriebenen Modellansatz, insbesondere ein neuronales Netz oder anderer selbstlernender Modellansatz, wobei mittels zuvor gemessener mechanischer Eigenschaften des Stahlbandes an unterschiedlichen Stellen der Walzstraße mit unterschiedlichen Soll- und Ist-Werten der Walzstraße das Modell trainiert wird zum Vorhersagen von ablaufenden Prozessen, insbesondere der Rekristallisation, der Ausscheidung oder der Umwandlung im Stahlband, um damit die möglichen mechanischen Eigenschaften des Stahlbandes zu unterschiedlichen Zeitpunkten und / oder in unterschiedlichen diskreten Abschnitten (A_{x,y,z}) während der Herstellung zu bestimmen.

Weiterhin weist das Prozessmodell ein datengetriebenes Modell auf, insbesondere ein neuronales Netz oder ein anderen selbstlernenden Modellansatz, wobei mittels zuvor gemessener mechanischer Eigenschaften des Stahlbandes an unterschiedlichen Stellen der Walzstraße mit unterschiedlichen Soll- und Ist-Werten der Walzstraße bei der Herstellung das Modell trainiert wird, um in Abhängigkeit von den Vorhersagen des Gefügemodells zu den mechanischen Eigenschaften, den vorgegebenen Zielwerte des Stahlbandes mögliche Soll-Werte für die Anlagen und daraus resultierende mögliche Ist-Werte der Produktionsanlagen der Walzstraße und resultierende mögliche Istwerte der zu den Zielwerten gehörenden Zieleigenschaften (Z_{x,y,z}) des Stahlbandes in den unterschiedlichen diskreten Abschnitten (A_{x,y,z}) vorherzusagen.

Weitere bevorzugte Ausführungen des Verfahrens sind in den abhängigen **Ansprüchen 2 bis 8** dargestellt.

Zumindest ein Sensor, mehr bevorzugt der Sensor zur Bestimmung der chemischen Zusammensetzung des Stahlbandes ist vorzugsweise an den diskreten Abschnitten (A_{x,y,z}), als Softsensor ausgebildet. Unter einem Softsensor im erfindungsgemäßen Sinne wird ein Sensor verstanden, der einen benötigten Messwert nicht physikalisch misst, sondern aus anderen Werten berechnet. Dies kann beispielsweise durch ein gesondertes Prozessmodell erfolgen.

Der Softsensor zur Bestimmung der chemischen Zusammensetzung des Stahlbandes berücksichtigt vorzugsweise die Seigerung während der Erstarrung des Vorproduktes, bevorzugt einer Bramme oder einer Dünnbramme, auf Basis einer Flüssigstahlstahlanalyse bei der Bestimmung der chemischen Zusammensetzung. Durch den Softsensor wird jedem diskretem Abschnitt (A_{x,y,z}) eine chemische Analyse zugewiesen.

Durch die Berücksichtigung der Seigerung bei der Erstarrung des Vorproduktes kann eine lokale chemische Zusammensetzung ermittelt werden, die sonst nur durch eine Zerstörung des Vorproduktes zugänglich ist. Die lokale chemische Zusammensetzung beeinflusst aber die Gefügeausbildung und Umformeigenschaften und damit auch die resultierenden Werkstoffeigenschaften. Eine Bestimmung der lokalen chemischen Analyse verbessert damit die Prozessregelung.

Die chemische Analyse des Vorprodukts ist vorzugsweise in Bezug auf die Länge nicht konstant. Nicht konstant im erfindungsgemäßen Sinne heißt, dass zwischen einer lokale mittleren chemische Analyse eines diskreten Abschnittes (A_{xyz}) und einem anderen diskreten Abschnitt (A_{xyz}) in der fraglichen Längenrichtung eine größere Abweichung auftritt, die nicht durch Seigerung bei der Erstarrung hervorgerufen wird.

Insbesondere bei einem Werkstoffwechsel im Strangguss ist die Flüssigstahlanalyse in der Kokille der Gießanlage nicht konstant. Der zeitliche Verlauf der Analyse wird bestimmt durch die Gießgeschwindigkeit und die Verweilzeit im Stranggussverteiler. Resultat ist ein Vorprodukt mit einer inhomogenen chemischen Analyse in Bezug auf die Länge des Vorproduktes.

Derartige Vorprodukte erzeugen bei einer konstanten Verarbeitung in einer Walzstraße ein zusätzliches inhomogenes Eigenschaftsprofil in Bezug auf die Länge des Vorproduktes. Das erfindungsgemäße Verfahren ermöglicht es auch bei diesen Vorprodukten das Eigenschaftsprofil so weit zu verbessern, das verwendbare Coils erzeugt werden können.

Das Prozessmodell weist vorzugsweise einen Optimierungsalgorithmus auf, der die Sollwerte hinsichtlich vorzugebender Ziele, insbesondere hinsichtlich der CO₂-Emission, der Kosten oder des Ausbringens, optimiert. Durch eine zusätzliche Optimierung können die Kosten und / oder der Umwelteinfluss der Herstellung verbessert werden.

Zumindest ein Temperatursensor wird bevorzugt im Verfahren verwendet und der Temperatursensor ist im Ofeneinlauf, im Walzwerkeinlauf, im Walzwerkauslauf, im Kühlstreckeneinlauf und / oder im Kühlstreckenauslauf angeordnet. Temperatursensoren liefern Messwerte, die für die Umformeigenschaften und die Gefügeausbildung in der Walzstraße relevant sind. Eine entsprechende Messung dieser Werte verbessert die Genauigkeit der Steuerung oder Regelung in Bezug auf das Eigenschaftsprofil.

Dies ist besonders vorteilhaft, wenn nicht nur punktuelle Messungen auf der Oberfläche erfolgen, sondern Linien- oder Flächenprofile der Temperatur ermittelt werden. Diese Linien- oder Flächenprofile der Temperatur können dann den entsprechenden diskreten Abschnitten (A_{xyz}) zugeordnet werden. Dadurch verbessert sich die Vorhersagegenauigkeit der verwendeten Modelle.

Das physikalische Modell nutzt bevorzugt zur Berechnung der mechanischen Eigenschaften ein für jeden diskreten Abschnitt (A_{x,y,z}) berechnetes Gefüge. Das Gefüge wird dabei vorzugsweise durch die jeweiligen Gefügebestandteile und Korngrößen der Gefügebestandteile und mehr bevorzugt unter Berücksichtigung weiterer Kenngrößen im physikalischen Modell abgebildet wird. Gefügebestandteile sind beispielsweise Austenit, Perlit, Ferrit, Martensit o.ä.. Weitere Kenngrößen sind beispielsweise Ausscheidungen bzw. Ausscheidungswachstum an den Korngrenzen, Diffusion von Bestandteilen.

Das physikalische Modell zur Berechnung der mechanischen Eigenschaften verwendet bevorzugt durch Sensoren in der Walzstraße ermittelte mechanischer Werte des Stahlbandes zur Optimierung der Berechnung der mechanischen Eigenschaften oder des Gefüges. Die Ermittlung der mechanischen Werte durch Sensoren der Walzstraße kann beispielsweise mittels Dehnungsmessstreifen an Walzgerüsten oder anhand der Durchbiegung eines Bandes zwischen zwei Walzgerüsten ermittelt werden. Weiterhin kann mittels eines Berechnungsmodells auf Basis von Messwerten, die nicht unmittelbar mit dem Walzprozess in Verbindung stehen, mechanische Messwerte eines Bandes bestimmt werden. Geeignet Messwerte dazu können beispielsweise die Stromaufnahme eines Motors oder hydraulische Druckschwankungen sein.

Weiterhin wird die Aufgabe der Erfindung durch eine Walzstraße mit den Merkmalen des Anspruchs 9 gelöst. Die Walzstraße ist geeignet zum Herstellen eines Stahlbandes gemäß einem der Ansprüche 1 bis 8.

Der Beschreibung sind die folgenden fünf Figuren beigefügt:
- Fig. 1:: Erfindungsgemäße Walzstraße
- Fig. 2:: Vorprodukt mit lokalen Abweichungen
- Fig. 3:: Ablaufdiagramm des Verfahrens
- Fig. 4:: Chemische Analyse, Gefügeausbildung im Vergleich zum Eigenschaftsprofil mit und ohne Verfahrensanpassung
- Fig. 5: Tab. 1:: Trainingsdatensatz

Die Erfindung wird nachfolgend unter Bezugnahme auf die Figuren detailliert beschrieben. In allen Figuren sind gleiche technische Elemente mit gleichen Bezugszeichen versehen.

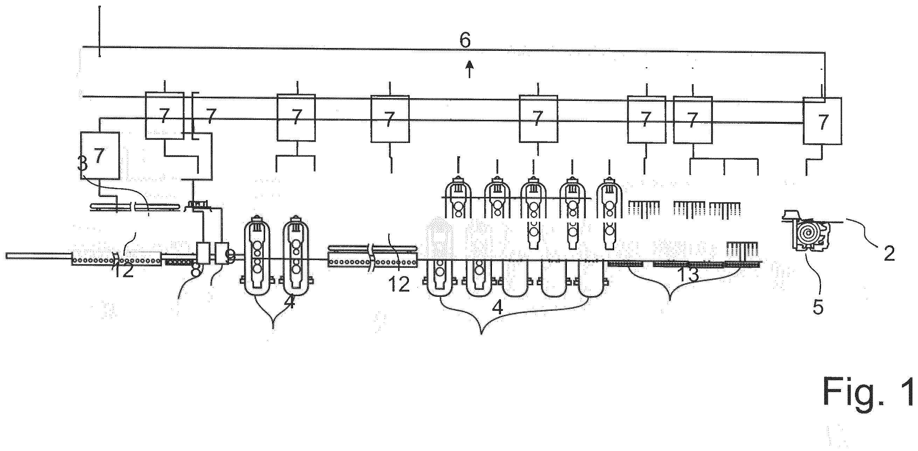

*Figur 1* zeigt eine erfindungsgemäße Walzstraße 1. Die Walzstraße 1 besteht aus, einem Vorwärmofen und einer Zwischenerwärmung als Wärmeinrichtungen 12, drei Vorwalzgerüsten fünf Fertigwalzgerüsten als Walzgerüste 4, einer zweistufigen Kühlstrecke 13 und einer Haspel 5. Alle Anlagen verfügen über eine jeweilige Regelung 7 und sind mit einer übergeordneten Anlagensteuerung 6 verbunden. Entlang dem Materialfluss in der Walzstraße 1 sind eine Vielzahl von Sensoren 8,9 zur Erfassung von Ist-Daten angeordnet.

Das Vorprodukt 3, eine Bramme, wird im Vorwärmofen 13 auf eine Temperatur oberhalb der Anstichtemperatur im ersten Vorwalzgerüst 4 aufgeheizt. Anschließend wird die Bramme 3 entzundert und mittels Laserscannern 8 geometrisch vermessen. Parallel dazu werden Temperaturprofile auf den Oberflächen der Bramme erstellt und die chemische Zusammensetzung ermittelt. Diese Messdaten werden den diskreten Abschnitten (A_{xyz}) auf der Oberfläche zugeordnet und daraus die inneren diskreten Abschnitte der Bramme interpoliert.

Weiterhin wird jedem diskreten Abschnitt (A_{xyz}) eine lokale chemische Analyse zugeordnet. Dies erfolgt auf Basis von Messdaten der chemischen Analyse mit dem zeitlichen Verlauf aus dem Strangguss der Bramme und einem Erstarrungsmodell, das zumindest die Seigerungen berücksichtigt. Ein Gefügemodell kann zusätzlich jedem diskreten Abschnitt ein lokales Ausgangsgefüge zuordnen.

Aus der Produktionsplanung sind zu produzierende Bänder mit ihren mittleren mechanischen Eigenschaften und mittleren Abmessungen als Sollvorgaben bekannt. Ein selbstlernendes Prozessmodell überprüft für die zu produzierende Bramme, ob die mechanischen und geometrischen Eigenschaften eingehalten werden können. Sofern dies möglich ist, werden die entsprechenden Sollvorgaben ermittelt und an die Anlagensteuerungen übergeben.

Während der Herstellung des Stahlbandes werden die Umformkräfte an den Walzgerüsten aufgenommen und dadurch die mechanischen Eigenschaften zu einem definierten Zeitpunkt bestimmt. Entsprechend dieser Messwerte wird der nachfolgende Herstellungsprozess angepasst.

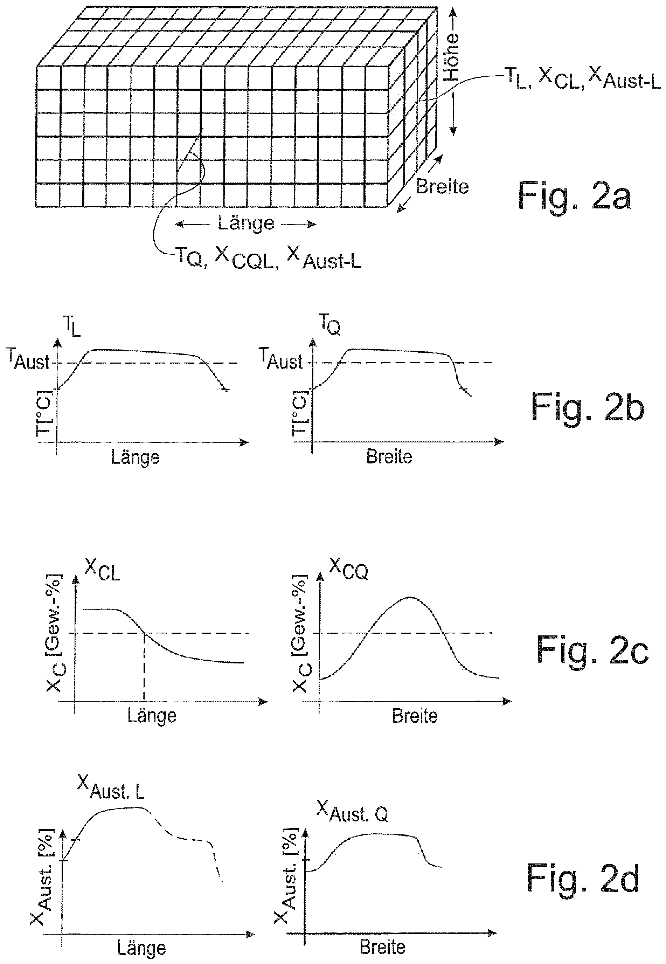

*Figur 2* stellt ein Vorprodukt, eine Bramme, mit seiner Einteilung in die diskreten Abschnitte (A_{xyz}) dar. Parallel dazu ist beispielhaft die Temperaturverläufe (T_{L}, T_{Q}), auf der Oberfläche der Kohlenstoffgehalt (x_{CL}, x_{CQ}) und ein Austenitgehalt (x_{A}) dargestellt. Diese unterschiedlichen Messwerte können durch eine Interpolation und ein Gefügemodell jedem diskreten Abschnitt der Bramme einen Wert zuweisen. Mit Hilfe dieser für die Bramme lokal aufgelösten Daten ist es dann möglich für den weiteren Herstellungsprozess Sollwerte für jeden diskreten Abschnitt zu ermitteln.

Beispielsweise kann die Kühlung bei an Kanten oder Enden der Bramme grundsätzlich reduziert werden. Weiterhin kann unter Berücksichtigung von ZTU- oder ZTA-Diagrammen für jedes diskrete Element eine mögliche Gefügeausbildung bestimmt werden. Durch eine lokal angepasste Kühlung können dann auch bei unterschiedlichen Ausgangsbedingungen durch die chemische Grundanalyse vergleichbare Gefüge und damit auch mechanische Eigenschaften eingestellt werden.

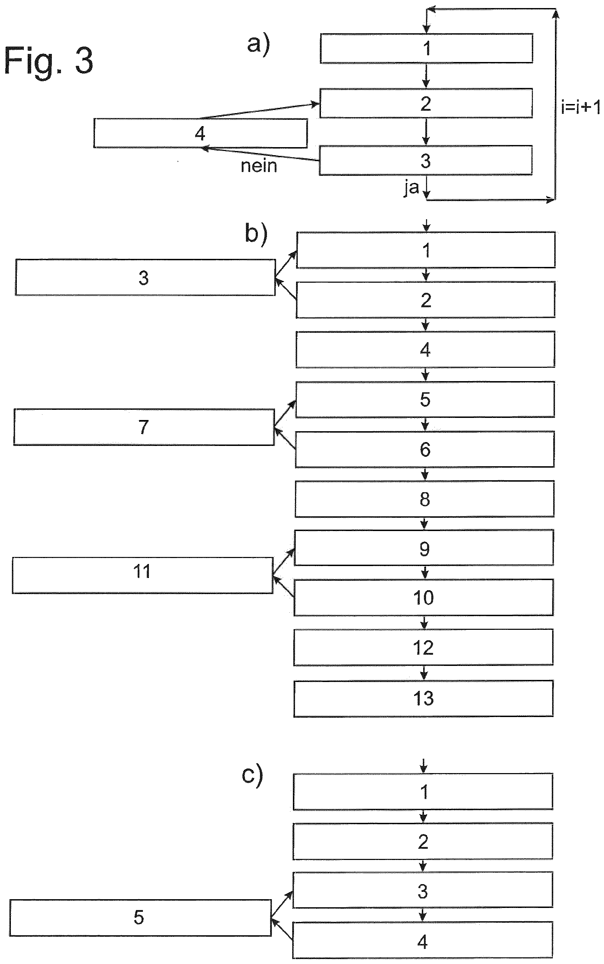

*Figur 3* mit den Abbildungen a) bis c) zeigen den schematischen Ablauf des erfindungsgemäßen Verfahrens bzw. die Abfolge einzelner Arbeitsschritte. In *Figur 3 a)* ist die verallgemeinerte Abfolge der Arbeitsschritte dargestellt. In Schritt 1 liegen zunächst für das Produkt die Istwert I_{xyz-i} für die Sollwerte Sᵢ vor. In dem nächsten Schritt 2 werden die Eigenschaften für das Produkt unter Berücksichtigung der Istwert I_{xyz-i} und der Sollwerte Sᵢ berechnet. Anschließend werden die berechneten Eigenschaften mit den Zielwerten Z_{xyz} des Produktes verglichen. Bei dem Vergleich kann eine zusätzliche Toleranzschwelle berücksichtigt werden, um ein Übersteuern bzw. Überschwingen zu vermeiden bzw. reduzieren. Entsprechen die berechneten Eigenschaften den Zielwerten Z_{xyz} oder sind innerhalb der Toleranzschwelle findet keine Veränderung der Sollwerte Si statt. Andernfalls werden einer oder mehrere Sollwerte Si so eingestellt, dass die berechneten Eigenschaften den Zielwerten Z_{xyz} entsprechen.

*Figur 3 b)* wendet beispielhaft die Schrittabfolge gemäß der Figur 3 a) auf einen Herstellungsprozess mit drei Temperaturmessstellen (12, 41, 5) an. In Schritt 1 sind die Sollwerte Sᵢ für die drei Temperaturmessstellen (12, 41, 5) vorgegeben. Weiterhin sind Zielwerte Z_{xyz} für die mechanischen Eigenschaften bestimmt worden. Mit diesen Vorgaben wird die Produktion begonnen (Schritt 2). Vor dem Erreichen der ersten Temperaturmessstelle 12 wird in einem ersten Durchlauf berechnet, ob die mit den Sollwerten Sᵢ berechneten Eigenschaften die Zielwerte Z_{xyz} erreicht werden. Werden die Zielwerte erreicht wird die Produktion mit den Sollwerten Si fortgesetzt. Andernfalls werden in Schritt 3 neue Sollwerte Si für die Produktion vorgegeben.

In Schritt 4 passiert das Produkt die erste Temperaturmessstelle und es werden Istwerte I_{xyz} gemessen. Mit diesen Istwerten I_{xyz} und den Sollwerten Sᵢ für die zweite und dritte Temperaturmessstelle (41, 5) werden erneut die mechanischen Eigenschaften des Produktes berechnet (Schritt 5) und mit den Zielwerten Z_{xyz} verglichen (Schritt 6). Sofern die Zielwerte nichterreicht werden, werden neue Sollwerte Sᵢ für eine oder beide Temperaturmessstellen (41, 5) vorgegeben.

Das Produkt erreicht in Schritt 8 die Temperaturmessstelle 41 und es werden Istwerte I_{xyz} gemessen. Unter Verwendung der Istwerte I_{xyz} der Temperaturmessstellen 12, 41 und der Sollwerte Si der Temperaturmessstelle 5 werden mechanische Eigenschaften des Produktes berechnet (Schritt 9) und mit den Zielwerten Z_{xyz} verglichen (Schritt 10). Bei einer Abweichung wird ein neuer Sollwert für die Temperaturmessstelle 5 vorgegeben. Mit dieser Vorgabe wird das Produkt fertiggestellt und es werden die Istwerte I_{xyz} an der Temperaturmessstelle 5 ermittelt. Nach Abschluss der Produktion werden alle gemessenen Istwerte, der Produktionsablauf mit ggf. den Abweichungen und den neuen Sollwerten Sᵢ, die im Prozess berechneten mechanischen Eigenschaften, die Zielwerte Z_{xyz} und die mechanischen Eigenschaften nach Abschluss der Produktion in einer Datenbank gespeichert.

In *Figur 3 c)* werden beispielsweise die im Ablauf der *Figur 3 b)* gewonnenen Daten dazu genutzt ein datengetriebenes Modell zu trainieren. Das datengetriebene Model ermittelt dabei die neuen Sollwerte Sᵢ im Verfahren. In Schritt 1 werden bekannte Datensätze aus einer konventionellen Produktion dem datengetriebenen Modell bereitgestellt. Mit diesen Datensätzen wird das datengetriebene Modell initial trainiert (Schritt 2). Mit diesem trainierten Modell wird die Produktion aufgenommen und der Datensatz mit dann anfallenden Istwerten und Produktionsdaten erweitert. Je nach Genauigkeit der Vorhersagen oder in einem zeitlichen Zyklus wird das Modell mit den initialen Daten und den neuen Daten nachtrainiert und die Vorhersagegenauigkeit überprüft.

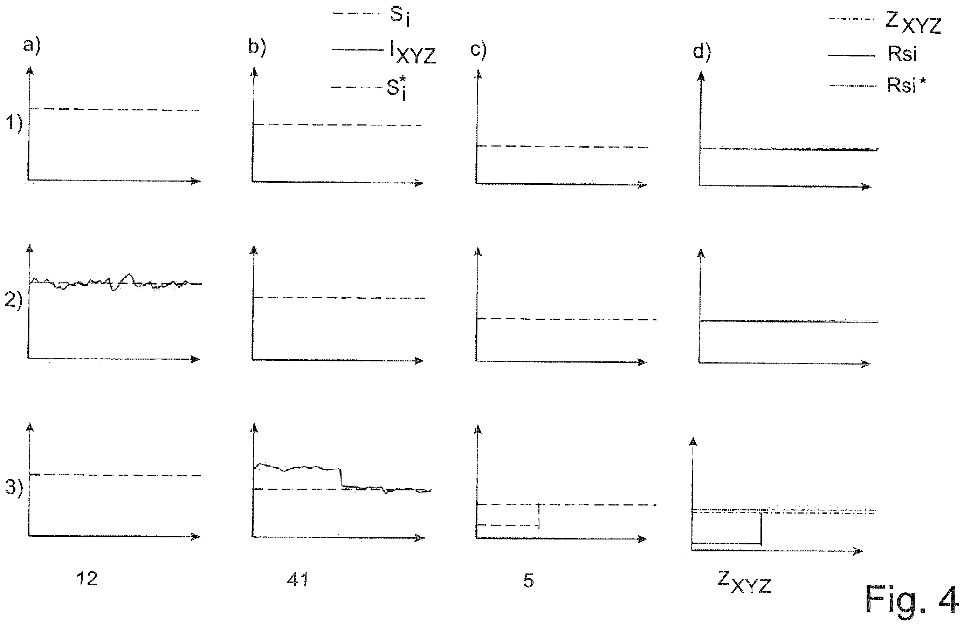

*Figur 4* zeigt 12 Diagramme einer Produktion mit Sollwerten Sᵢ, Istwerten l_{xyz}, berechneten mechanischen Eigenschaften und den Zielwerten Z_{xyz} im Prozessverlauf dar. Die Spalte a) entspricht der Temperaturmessstelle 12 und der zeitliche Verlauf entspricht der Reihe 1) bis 3). Spalte b) und c) entsprechen den Temperaturmessstellen 41 und 5. Die jeweiligen berechneten mechanischen Eigenschaften zu den unterschiedlichen Zeitpunkten 1) bis 3) sind in der Spalte d) dargestellt.

Zum Zeitpunkt 1) sind für die Temperaturmessstellen unterschiedliche Sollwerte Sᵢ vorgegeben. Die daraus berechneten mechanischen Eigenschaften entsprechen den Zielwerten Z_{xyz}. Zum Zeitpunkt 2) passiert das Produkt die Temperaturmessstelle 12 und es werden Istwerte I_{xyz} für das Produkt ermittelt. Die mit den Sollwerten Sᵢ und den Istwerten I_{xyz} errechneten mechanischen Eigenschaften entsprechen den Zielwerten Z_{xyz}. Die Produktion wird mit den bestehenden Sollwerten Sᵢ fortgesetzt. Zum Zeitpunkt 3) wird im Verlauf der Temperaturmessstelle 41 ein sprunghafter Anstieg der Temperatur im zeitlichen bzw. im Bezug auf die Produktlänge festgestellt. D.h. es liegt eine Abweichung des Istwertes von dem Sollwert vor. Ohne einen weiteren Eingriff bzw. Vorgabe neuer Sollwerte würde hieraus eine abweichende mechanische Eigenschaft über die Bandlänge entstehen.

Für die weitere Produktion werden in Bezug auf die Bandlänge bzw. ein zeitlich variabler neuer Sollwert für die Temperaturmessstelle 5 vorgegeben (Diagramm c)-3)), so dass die berechneten und tatsächlichen mechanischen Eigenschaften den Zielwerten entsprechen.

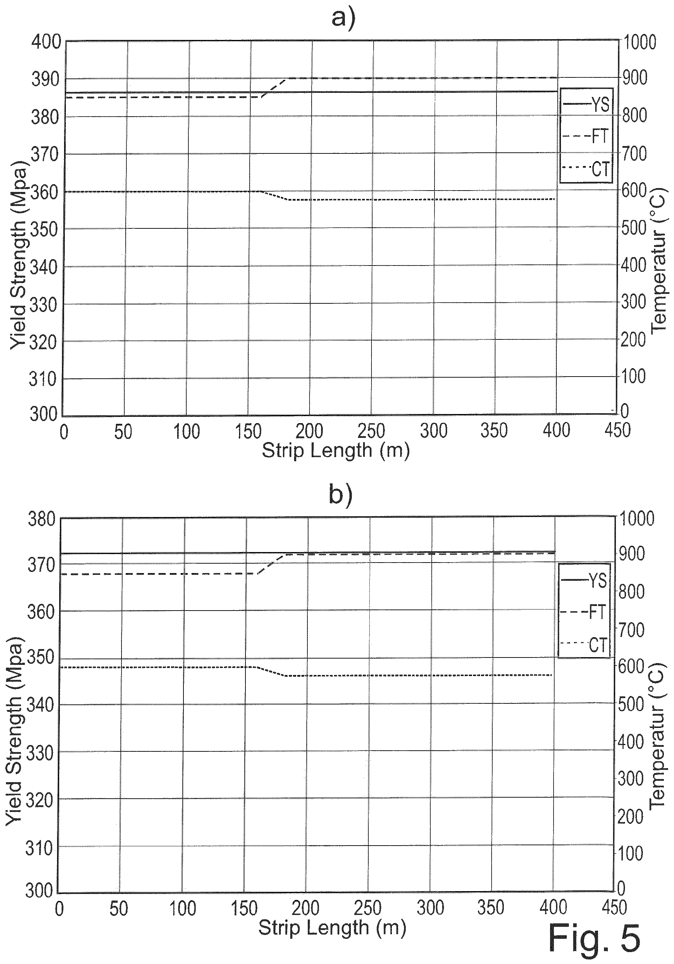

In *Figur 5* sind in den Diagrammen a) und b) die Ergebnisse unterschiedlicher Modellberechnungen über die Bandlänge für den Zusammenhang der Streckgrenze YT, der Fertigwalztemperatur FT, der Haspeltemperatur CT sowie weiterer Bandeigenschaften dargestellt.

Diagramm a) zeigt den berechneten Verlauf von der Streckgrenze YT über die Bandlänge. Die Streckgrenze wurde mit einem aus dem Stand der Technik bekannten physikalischen Modellansatz berechnet (Prediction of the Mechanical Properties of Hot-Rolled Low Carbon Steel Strips in Correlation to Chemical Compositions and Rolling Conditions, January 2011, Key Engineering Materials 462-463:401-406)*.* Der sprunghafte Temperaturanstieg bei einer Bandlänge von 175 m führt zu einem Absinken der Streckgrenze. Durch ein Absenken der Haspeltemperatur CT als Sollwert kann der Zielwert für die Streckgrenze über die Bandlänge erreicht werden.

Diagramm b) zeigt den berechneten Verlauf der Streckgrenze YT über die Bandlänge, wobei die Berechnung mit einem datengetriebenen Modell erfolgt ist. Das Modell wurde mit den Daten gemäß der Tabelle 1 initial trainiert. Die Trainingsdaten umfassen die Streckgrenze, die chemische Analyse, die Banddicke und - breite, die Fertigwalztemperatur und die Haspeltemperatur. Mit Hilfe des datengetriebenen Modells ist die abweichende Fertigwalztemperatur FT durch eine Anpassung der Haspeltemperatur CT ausgeglichen worden.

**Tabelle 1**

| chem. Analyse[Gew.-%] | | | | | | | | | | | | | | | | | | | |
|---|---|---|---|---|---|---|---|---|---|---|---|---|---|---|---|---|---|---|---|
| YS[MPA] | C | Mn | P | S | Si | Cu | Ni | Cr | V | Ti | Nb | Mo | B | Al | Sn | d(mm) | b(mm) | FT[°C] | CT[°C] |
| 400 | 0,054 | 0,79 | 0,012 | 0,006 | 0,10 | 0,101 | 0,04 | 0,03 | 0,010 | 0,013 | 0,012 | 0,014 | 0.000 | 0,029 | 0,000 | 2,054 | 1495 | 844 | 586 |
| 384 | 0,050 | 0,82 | 0,012 | 0,010 | 0,10 | 0,108 | 0,03 | 0,03 | 0,011 | 0,014 | 0,010 | 0,014 | 0,000 | 0,027 | 0,000 | 3,638 | 1443 | 856 | 611 |
| 374 | 0,062 | 0,77 | 0,012 | 0,005 | 0,10 | 0,102 | 0,03 | 0,03 | 0,012 | 0,014 | 0,011 | 0,013 | 0,000 | 0,029 | 0,000 | 2,732 | 1786 | 841 | 612 |
| 416 | 0,059 | 0,83 | 0,012 | 0,007 | 0,11 | 0,103^{.} | 0,03 | 0,03 | 0,010 | 0,011 | 0.013 | 0,012 | 0,000 | 0,029 | 0,000 | 3,071 | 1571 | 834 | 581 ' |
| 393 | 0,068 | 0,79 | 0,015 | 0,010 | 0,11 | 0,105 | 0,03 | 0,03 | 0,015 | 0,011 | 0.014 | 0,012 | 0,000 | 0,026 | 0,000 | 3,063 | 1587 | 826 | 611 ' |
| 409 | 0,062 | 0.83 | 0,011 | 0,008 | 0.11 | 0,104 | 0,04 | 0,03 | 0,014 | 0,013 | 0,013 | 0,010 | 0,000 | 0,026 | 0,000 | 3,120 | 1420 | 879 | 597 |
| 391 | 0,061 | 0,81 | 0,012 | 0.005 | 0.11 | 0,111 | 0,03 | 0,03 | 0,012 | 0,012 | 0,013 | 0,012 | 0.000 | 0,026 | 0,000 | 3,967 | 1517 | 825 | 611 |
| 391 | 0,057 | 0,77 | 0,011 | 0,006 | 0,10 | 0.108 | 0,04 | 0,03 | 0,010 | 0,014 | 0,015 | 0,011 | 0,000 | 0.027 | 0.000 | 3,469 | 1760 | 830 | 612 |
| 389 | 0,056 | 0,83 | 0,011 | 0,007 | 0,10 | 0,113 | 0,03 | 0,03 | 0,013 | 0,015 | 0,010 | 0,014 | 0,000 | 0,029 | 0,000 | 2,849 | 1785 | 888 | 612 |
| 380 | 0,052 | 0,81 | 0,013 | 0,006 | 0,10 | 0,102 | 0,04 | 0,03 | 0,013 | 0,015 | 0,012 | 0,011 | 0,000 | 0,026 | 0,000 | 2,787 | 1525 | 853 | 602 |
| 414 | 0,061 | 0,84 | 0,013 | 0,05 | 0,11 | 0,111 | 0,03 | 0,03 | 0,014 | 0,015 | 0,014 | 0,013 | 0,000 | 0,030 | 0,000 | 2,771 | 1524 | 851 | 584 |
| 382 | 0,059 | 0,77 | 0,013 | 0,008 | 0,11 | 0,109 | 0,03 | 0,03 | 0,012 | 0,012 | 0,010 | 0,011 | 0,000 | 0,027 | 0,000 | 2,410 | 1515 | 836 | 601 |
| 417 | 0,065 | 0,82 | 0,014 | 0,009 | 0,11 | 0,112 | 0,04 | 0,03 | 0,011 | 0,013 | 0,012 | 0,010 | 0,000 | 0,029 | 0,000 | 3,927 | 1513 | 840 | 592 |
| 420 | 0,052 | 0,82 | 0,012 | 0,010 | 0,10 | 0,103 | 0,04 | 0,03 | 0,013 | 0,013 | 0,014 | 0,012 | 0,000 | 0,026 | 0,000 | 3,238 | 1654 | 839 | 607 |
| 395 | 0,051 | 0,82 | 0,013 | 0,007 | 0,11 | 0,107 | 0,04 | 0,03 | 0,014 | 0,013 | 0,011 | 0,014 | 0,000 | 0,028 | 0,000 | 3,793 | 1732 | 824 | 585 |
| 409 | 0,062 | 0,80 | 0,012 | 0,010 | 0,11 | 0,101 | 0,04 | 0,03 | 0,014 | 0,011 | 0,011 | 0,010 | 0,000 | 0,025 | 0',000 | 2,059 | 1498 | 839 | 584 |
| 395 | 0,061 | 0,81 | 0,011 | 0,006 | 0,11 | 0,106 | 0,04 | 0,03 | 0,012 | 0,010 | 0,015 | 0,015 | 0,000 | 0,027 | 0,000 | 3,308 | 1443 | 835 | 585 |
| 379 | 0,059 | 0,80 | 0,012 | 0,008 | 0,11 | 0,109 | 0,03 | 0,03 | 0,014 | 0,013 | 0,015 | 0,012 | 0,000 | 0,029 | 0,000 | 3,031 | 1705 | 885 | 589 |
| 409 | 0,069 | 0,76 | 0,014 | 0,007 | 0,11 | 0,109 | 0,04 | 0,03 | 0,010 | 0,012 | 0,014 | 0,010 | 0.000 | 0,028 | 0,000 | 3,899 | 1568 | 854 | 582 |
| 375 | 0,052 | 0,78 | 0,011 | 0,005 | 0,10 | 0,109 | 0,04 | 0,03 | 0,011 | 0,015 | 0,014 | 0,013 | 0.000 | 0.026 | 0,000 | 3,381 | 1576 | 847 | 583 |
| 425 | 0,055 | 0,75 | 0,015 | 0,008 | 0,11 | 0,102 | 0,04 | 0,03 | 0,011 | 0,010 | 0,015 | 0,011 | 0.000 | 0,026 | 0,000 | 3.386 | 1616 | 843 | 613 |
| 376 | 0,064 | 0,80 | 0,012 | 0,008 | 0,11 | 0,104 | 0,04 | 0,03 | 0.012 | 0,012 | 0,014 | 0,012 | 0.000 | 0,029 | 0,000 | 3.360 | 1456 | 869 | 589 |
| 389 | 0.058 | 0,84 | 0,0131 | 0,007 | 0,11 | 0,107 | 0,04 | 0,03 | 0,011 | '0,010 | 0,015 | 0,015 | 10,000 | 0,026 | 0,000 | 2,830 | 1506 | 820 | 607 |
| 407 | 0,068 | 0,82 | 0.013 | 0,007 | 0,10 | 0,105 | 0,04 | 0.03 | 0,014 | 0,013 | 0,012 | 0,015 | 0,000 | 0,026 | 0.000 | 2,279 | 1611 | 892 | 597 |
| 423 | 0,057 | 0.78 | 0,012 | 0,007 | 0,11 | 0,112 | 0,04 | 0,03 | 0,011 | 0,011 | 0,012 | 0,012 | 0,000 | 0,028 | 0.000 | 3.759 | 1719 | 832 | 601 |
| 394 | 0,058 | 0,80 | 0,014 | 0,008 | 0,11 | 0,108 | 0,04 | 0,03 | 0,012 | 0,014 | 0,013 | 0.013 | 0,000 | 0,030 | 0,000 | 3,431 | 1439 | 881 | 593 |
| 362 | 0,056 | 0,81 | 0,012 | 0,005 | 0.10 | 0,112 | 0,04 | 0,03 | 0,011 | 0,015 | 0,011 | 0,013 | 0,000 | 0,030 | 0,000 | 3,690 | 1552 | 846 | 601 |
| 358 | 0,051 | 0,84 | 0,014 | 0,008 | 0,10 | 0,114 | 0,04 | 0,03 | 0,011 | 0,010 | 0,011 | 0,015 | 0,000 | 0,029 | 0.000 | 3,644 | 1560 | 879 | I 615 |
| 357 | 0,059 | 0,78 | -0,011 | 0.005 | 0,10 | 0,111 | 0,04 | 0,03 | 0,013 | 0,012 | 0,011 | 0,013 | 0.000 | 0,029 | 0,000 | 3.772 | 1443 | 877 | 615 |
| 365 | 0,062 | 0,81 | 0,011 | 0,009 | 0,10 | 0,110 | 0,04 | 0,03 | 0,012 | 0,012 | 0,012 | 0,014 | 0,000 | 0,029 | 0,000 | 3,401 | 1520 | 840 | 601 |
| 427 | 0,058 | 0,84 | 0,013 | 0.007 | 0,10 | 0,111 | 0.03 | 0,03 | 0.015 | 0.014 | 0,011 | 0,012 | 0,000 | 0,028 | 0,000 | 3.133 | 1586 | 850 | 591 |
| 422 | 0.058 | 0,83 | 0,010 | 0,009 | 0,11 | 0,104 | 0,03 | 0,03 | 0,011 | 0,010 | 0,014 | 0,011 | 0.000 | 0,027 | 0,000 | 2,597 | 1432 | 863 | 618 |
| 401 | 0,068 | 0,75 | 0,010 | 0,007 | 0,10 | 0,101 | 0,04 | 0,03 | 0,011 | 0,011 | 0,013 | 0,013 | 0,000 | 0,029 | 0,000 | 3,463 | 1533 | 862 | 620 |

**Bezugszeichenliste:**

| Bezugszeichen | Bedeutung |
|---|---|
| 1 | Walzstraße |
| 2 | Stahlband |
| 3 | Vorprodukt |
| 4 | Walzegrüste |
| 41 | Fertigstraßenauslauf |
| 5 | Haspel |
| 6 | übergeordnete Prozesssteuerung |
| 7 | Anlagensteuerung |
| 8 | Dickensensor |
| 9 | Sensor für die chemische Zusammensetzung |
| 10 | Prozessmodell |
| 11 | Gefügemodell |
| 12 | Wärmeinrichtung |
| 13 | Kühlstrecke |
| Sᵢ | Sollwerte |
| Sᵢ^{*} | Neue Sollwerte |
| RSᵢ | Rechwerte |
| RSᵢ* | Neue Rechenwerte |
| L | Länge |
| t | Zeit |
| Z_{xyz} | Zielwerte |
| Axyz | Diskreter Abschnitt |
| N | Prozessschritt |
| Sᵢ | Sollwerte |
| I_{xyz} | Istwerte |

## Patentansprüche

1. **Verfahren** zum Herstellen eines Stahlbandes (2) aus einem Vorprodukt (3) bei dem die Sollwerte (Sᵢ) über die Länge (L) eines einzelnen Stahlbandes und / oder zeitlich (t) in Bezug auf eine einzelne Produktionsanlage einer Walzstraße (1) variabel vorgegeben werden, wobei die Herstellung des Stahlbandes (2) mittels der Walzstraße (1) erfolgt und die Walzstraße (1) zumindest ein Wärmeinrichtung (12), ein Walzgerüst (4), eine Haspel (5), eine übergeordnete Prozesssteuerung (6) die in Verbindung mit den Steuerungen (7) der beteiligten Produktionsanlagen steht und Sensoren (8) zur Dickenmessung, zur Profilmessung und / oder einem Sensor (9) zur Messung der chemischen Zusammensetzung aufweist und bei dem die Arbeitsschritte ablaufen
- Einteilen des Stahlbandes (1) in diskrete Abschnitte (A_{x,y,z});
- Zuweisen von Zielwerten des Stahlbandes (Z_{x,y,z}) für jeden diskreten Abschnitt (A_{x,y,z}) des Stahlbandes in Bezug auf den auszuführenden Prozessschritt (N) an einer einzelnen Produktionsanlage;
- Zuweisen von Sollwerten (Sᵢ) für jede auf einer Produktionsanlage der Walzstraße (1) auszuführenden Prozessschrittes (N) mittels eines Prozessmodells (10);
- Messen von Istwerten (I_{x,y,z}) für eine Vielzahl der diskreten Abschnitte (A_{x,y,z}) des Stahlbandes (1) während der Herstellung des Stahlbandes (1);
- Bei Abweichungen der Istwerte (I_{x,y,z}) von den Sollwerten (Sᵢ) bestimmen und übergeben von neuen Sollwerten (S_{i,n}) durch das Prozessmodell (10)
**dadurch gekennzeichnet, dass**
- die den Produktionsanlagen der Walzstraße (1) zugewiesenen Sollwerte (Sᵢ) der Prozessschritte (N) mittels des Prozessmodells (10) vor und während der Herstellung eines einzelnen Stahlbandes (2) ermittelt werden; und
- das Prozessmodell (10) bei der Bestimmung von neuen Sollwerten (S_{i,n}) während der Herstellung eines einzelnen Stahlbandes (2) Ist-Werte (I_{x,y,z}) des in der Herstellung befindlichen Stahlbandes (2) berücksichtigt;
- das Prozessmodell (10) ein Gefügemodell (11) zur Ermittlung der Sollwerte (Sᵢ) aufweist, wobei das Gefügemodell (11) mindestens einen der beiden folgenden Modellansätze verwendet:
i. einen physikalischen Modellansatz, aufweisend physikalische und / oder empirische Gleichungen zum Berechnen von ablaufenden Prozessen im Stahlband (2), insbesondere der Rekristallisation, der Ausscheidung oder der Umwandlung im Stahlband (2), um damit die mechanischen Eigenschaften des Stahlbandes zu unterschiedlichen Zeitpunkten während der Herstellung und / oder in unterschiedlichen diskreten Abschnitten (A_{x,y,z}) zu berechnen,
ii. einen physikalischen Modellansatz in Verbindung mit einem datengetriebenen Modellansatz, insbesondere ein neuronales Netz oder anderer selbstlernender Modellansatz, wobei mittels zuvor gemessener mechanischer Eigenschaften des Stahlbandes (2) an unterschiedlichen Stellen der Walzstraße (1) mit unterschiedlichen Soll- und Ist-Werten der Walzstraße (1) das Modell trainiert wird zum Vorhersagen von ablaufenden Prozessen, insbesondere der Rekristallisation, der Ausscheidung oder der Umwandlung im Stahlband (2), um damit die möglichen mechanischen Eigenschaften des Stahlbandes (2) zu unterschiedlichen Zeitpunkten und / oder in unterschiedlichen diskreten Abschnitten (A_{x,y,z}) während der Herstellung zu bestimmen;
und
- das Prozessmodell (10) ein datengetriebenes Modell aufweist, insbesondere ein neuronales Netz oder ein anderer selbstlernender Modellansatz, wobei mittels zuvor gemessener mechanischer Eigenschaften des Stahlbandes (2) an unterschiedlichen Stellen der Walzstraße (1) mit unterschiedlichen Soll- und Ist-Werten der Walzstraße (1) bei der Herstellung das Modell trainiert wird, um in Abhängigkeit von den Vorhersagen des Gefügemodells (11) zu den mechanischen Eigenschaften, den vorgegebenen Zielwerte des Stahlbandes (2) mögliche Soll-Werte für die Anlagen (Sᵢ) und daraus resultierende mögliche Ist-Werte der Produktionsanlagen der Walzstraße (1) und resultierende mögliche Istwerte der zu den Zielwerten gehörenden Zieleigenschaften (Z_{x,y,z}) des Stahlbandes (2) in den unterschiedlichen diskreten Abschnitten (A_{x,y,z}) vorherzusagen.

2. Verfahren nach Anspruch 1,
**dadurch gekennzeichnet, dass**
- zumindest ein Sensor (9), vorzugsweise der Sensor (9) zur Bestimmung der chemischen Zusammensetzung des Stahlbandes (2) an den diskreten Abschnitten (A_{x,y,z}), als Softsensor ausgebildet ist.

3. Verfahren nach Anspruch 2,
**dadurch gekennzeichnet, dass**
- der Softsensor zur Bestimmung der chemischen Zusammensetzung des Stahlbandes (2) die Seigerung während der Erstarrung des Vorproduktes (3), vorzugsweise einer Bramme oder Dünnbramme, auf Basis einer Flüssigstahlstahlanalyse bei der Bestimmung der chemischen Zusammensetzung berücksichtigt; und
- durch den Softsensor jedem diskretem Abschnitt (A_{x,y,z}) eine chemische Analyse zugewiesen wird.

4. Verfahren nach Anspruch 3
**dadurch gekennzeichnet, dass**
die chemische Analyse des Vorprodukts (3) in Bezug auf die Länge nicht konstant ist.

5. Verfahren nach einem der vorangegangenen Ansprüche,
**dadurch gekennzeichnet, dass**
das Prozessmodell (10) einen Optimierungsalgorithmus aufweist, der die Sollwerte (Sᵢ) hinsichtlich vorzugebender Ziele, insbesondere hinsichtlich der CO₂-Emission, der Kosten oder des Ausbringens, optimiert.

6. Verfahren nach einem der vorangegangenen Ansprüche,
**dadurch gekennzeichnet, dass**
- zumindest ein Temperatursensor im Verfahren verwendet wird; und
- der Temperatursensor im Ofeneinlauf, im Walzwerkeinlauf, im Walzwerkauslauf, im Kühlstreckeneinlauf und / oder im Kühlstreckenauslauf angeordnet ist.

7. Verfahren nach einem der vorangegangenen Ansprüche,
**dadurch gekennzeichnet, dass**
- das physikalische Modell zur Berechnung der mechanischen Eigenschaften ein für jeden diskreten Abschnitt (A_{x,y,z}) berechnetes Gefüge nutzt; und
- das Gefüge durch die jeweiligen Gefügebestandteile und Korngrößen der Gefügebestandteile und bevorzugt weiterer Kenngrößen im Modell abgebildet wird.

8. Verfahren nach Anspruch 7,
**dadurch gekennzeichnet, dass**
- das physikalische Modell zur Berechnung der mechanischen Eigenschaften durch Sensoren in der Walzstraße ermittelte mechanischer Werte des Stahlbandes (2) zur Optimierung der Berechnung der mechanischen Eigenschaften oder des Gefüges verwendet.

9. **Walzstraße** geeignet zum Herstellen eines Stahlbandes gemäß einem der Ansprüche 1 bis 8.
